# EUROPEAN PATENT APPLICATION

(11) **EP 4 716 372 A1**
(43) Date of publication of application: **25.03.2026**
(21) Application number: 25203298.2
(22) Date of filing: 19.09.2025
(51) Int. Cl.: H05B 45/20, G01R 31/26, H05B 47/175, H05B 45/28, F21S 8/00, H02S 50/10

(54) **LIGHT EMISSION DEVICE**

(30) Priority: 19.09.2024 IT 202400020908
(71) Applicant: Ecoprogetti S.R.L., 35010 Carmignano di Brenta (PD) (IT)
(72) Inventor: Sartore, Domenico, 35010 Carmignano di Brenta (PD) (IT); Moretti, Francesco, 35015 Galliera Veneta (PD) (IT); Lago, Nicolò, 36028 Rossano Veneto (VI) (IT); Quartiani, Federico, 35010 Grantorto (PD) (IT)
(74) Representative: Petraz, Gilberto Luigi

(57) **Abstract**

Light emission device (10) for performing tests on at least one object and provided with at least one lighting unit (11) having at least one electronic support (13) on which a plurality of LED light emitters (14) are disposed in a flat matrix, and at least one command unit (12), wherein the lighting unit (11) comprises at least a connection interface (20), a plurality of lighting channels (101-116), each consisting of one or more light emitters (14), and at least a control element (15) configured to measure the temperature of at least part of the light emitters (14); and wherein the command unit (12) comprises a plurality of command channels (201-208) independent of each other and each configured to deliver at output a given electric signal to at least one corresponding one of the lighting channels (101-116), a command interface (21) electronically connected to each of the command channels (201-208) and configured to be selectively interconnected with the connection interface (20), and at least one connection input (17) configured to be electronically connected to the control element (15).

## Description

### FIELD OF THE INVENTION

The present invention concerns a light emission device of the type used, for example, to simulate solar radiation in simulator apparatuses whose primary function is to test, in a continuous mode, that is, for an extended period of time, even for entire days, the operation of photovoltaic modules or panels, or photovoltaic strings or cells, hereafter referred to with the general term "object", by recreating, within a closed radiation chamber in which the object is housed, an artificial light using LED light sources.

Although the description specifically refers to the simulation of solar radiation on the ground, it is not excluded that other types of light radiation can be simulated with the solution according to the present invention, for example albedo, solar radiation in space, special interior lighting, or suchlike.

### BACKGROUND OF THE INVENTION

In the photovoltaic panel manufacturing sector, the need to test photovoltaic panels, strings or cells before they are released to market is known. This is achieved by irradiating the panels for a certain period of time, even prolonged, up to whole days, with an artificial light that simulates the conditions of exposure to natural sunlight, in order to measure characteristic parameters such as the I-V curve, for example.

To perform this type of tests, numerous solar simulator apparatuses are known, which essentially comprise a containing structure inside which an irradiation chamber is made, provided with an LED lighting plane and a rest plane directly facing the lighting plane and on which the object to be tested is disposed, on each occasion.

The lighting plane provides an irradiating surface, which is directly associated with a light emission device, in turn provided with a plurality of LED boards that are suitably powered and controlled, by means of corresponding control boards, to generate artificial light. The individual LEDs of each board are capable of emitting beams of light at different wavelengths in order to determine an overall radiation as similar as possible to the natural solar spectrum.

US 2011/0241549 discloses a light emitter that can be used as a solar simulator. This document discloses the use of solid state emitters to simulate the light emitted by the sun. This document generically discloses that each emitter can have any type of emission angle whatsoever, without specifying particular optimized angles. Furthermore, although this document refers to an emission range with wavelengths between 300 and 1400 nm, these wavelengths are obtained through the choice of materials with which the optics are made.

A disadvantage of known simulator apparatuses is that, once switched on, the LED boards generate a considerable thermal flow which, if not properly dissipated, leads to a rapid overheating thereof, thus compromising the quality of the test because of the distortion of the emission wavelengths of the LEDs themselves.

This disadvantage proves to be particularly problematic especially in tests with a continuous and prolonged duration, for example of several days, for which thermal control, especially of the irradiating surface but also of the object subjected to lighting, is essential in order to obtain reliable results.

Furthermore, known emission devices have the disadvantage of being designed and manufactured in a pre-paired manner, with LED switching on and off sequences that are predefined in the programming phase, and substantially without the possibility of a voltage and current feed-back actually applied, that is, without being able to pair, add or replace only part of the device to selectively vary the conditions of use and simulation. This disadvantage limits the potential industrial applications of the light emission device of a known type, unless it is fully replaced, resulting in increased costs and reduced productivity of the apparatuses on which it is installed.

With known solutions there is, on the one hand, a substantial rigidity in the application of the light emission devices and, on the other hand, the impossibility of effectively controlling the current, substantially preventing the possibility of varying the timing and duration of the light emissions.

There is therefore the need to perfect a light emission device that can overcome at least one of the disadvantages of the state of the art.

To do this, it is necessary to resolve the technical problem of allowing to constantly monitor the temperature in order to signal overheating or faults, modulating the current values of the individual channels in real time to ensure constant irradiance for the entire duration of a flash, or during consecutive flashes, as well as enabling the switching on and off of individual LED channels at a controlled current to generate short light pulses, such as long-duration flashes.

In particular, one purpose of the present invention is to provide a light emission device that can remain active in continuous mode without loss of efficiency or quality of the artificial light produced, reducing, or at least managing in real time, the overheating of its components, thus maintaining a high quality of the light emission performed.

Another purpose of the present invention is to provide a light emission device of a substantially modular type, which allows high flexibility of use and application without requiring its complete replacement.

The Applicant has devised, tested and embodied the present invention to overcome the shortcomings of the state of the art and to obtain these and other purposes and advantages.

### SUMMARY OF THE INVENTION

The present invention is set forth and characterized in the independent claims. The dependent claims describe other characteristics of the present invention or variants to the main inventive idea.

In accordance with the above purposes and to resolve the technical problem disclosed above in a new and original way, also achieving considerable advantages compared to the state of the prior art, a light emission device according to the present invention can find advantageous, but not limited, application in performing tests on at least one object, such as a photovoltaic panel, a photovoltaic string or cell.

In particular, the light emission device according to the present invention is particularly suited to be used as a solar simulator, since it allows to simulate various shapes of the emission spectrum with a range that can vary from 300 to 1300 nm. It should be noted that this emission spectrum is obtained directly from the light source, thus being an integral part of the device without reference to additional components.

The device according to the present invention comprises a lighting unit and a command unit, electronically interconnected with each other.

The lighting unit can be of the type provided with at least one electronic support, such as for example an aluminum plate or other, in any case with high thermal conductivity to dissipate heat and, advantageously, with a matte black background to avoid any reflections, on which a plurality of LED light emitters are disposed in a flat matrix. The electronic support is configured to position at least some of the light emitters toward the object to be tested, according to the desired operating conditions provided by the various standards.

The command unit is, instead, configured to command the selective activation of one, or of groups, of light emitters.

In accordance with one aspect of the present invention, the lighting unit comprises at least one connection interface, which is mounted on the electronic support and is electronically connected to the light emitters. Moreover, the lighting unit comprises a plurality of lighting channels, which are independent of each other, and each consist of one or more light emitters, for example connected to each other in series. One or more control elements are also part of the lighting unit according to the present invention, for example of the NTC *(Negative Temperature Coefficient*) thermistor type, mounted on the electronic support and configured to measure the temperature of at least part of the light emitters.

According to one aspect of the present invention, the command unit comprises a plurality of command channels, independent of each other, each of which is configured to deliver a certain electric signal to at least one corresponding lighting channel. In the same command unit there is provided a command interface, which is electronically connected to each of the command channels and is configured to be selectively interconnected with the lighting unit's connection interface, so as to selectively interconnect the two units.

At least one connection input is also part of the command unit, which is configured to be electronically connected to the control element so as to receive from the latter an electric signal corresponding to the measurement detected.

The solution according to the present invention therefore provides the possibility of electronically connecting individual and dedicated command channels to individual and dedicated channels of LED light emitters, enabling the switching on and off of individual LED channels at a controlled current so as to generate short light pulses, as well as long-duration flashes. Each LED channel is constantly monitored in terms of voltage and current by the control element(s) to guarantee correct operation; furthermore, a processing of the electric signals emitted by the individual channels and by the control elements allows to constantly monitor the temperature, so as to signal any overheating or faults, as well as manage a possible cooling system externally associated with the device according to the present invention.

In this way, it is possible to modulate the current values of the individual channels in real time to ensure a constant irradiance, both for the entire duration of a flash and also during consecutive flashes.

Thanks to this configuration, the light emission device according to the present invention can remain active in continuous mode without any loss of efficiency or quality of the artificial light produced, reducing, or at least managing in real time, the overheating of its components, thus maintaining a high quality of the light emission performed.

Furthermore, since the lighting unit and the command unit are selectively electronically connectable to each other by means of the corresponding connection and command interfaces, the light emission device according to the present invention is substantially of the modular type and allows a high flexibility of use and application, without requiring its complete replacement in the event of breakage or partial malfunction.

The solution according to the present invention guarantees a constant monitoring of the temperature to signal any overheating or faults, the possibility of modulating the current values of the individual channels in real time to ensure a constant irradiation for the entire duration of a flash, or during consecutive flashes, as well as the switching on and off of individual LED channels at a controlled current to generate short light pulses, such as long-duration flashes.

In accordance with another aspect of the present invention, the lighting unit comprises sixteen lighting channels, each consisting of up to a maximum of nine light emitters connected in series with each other and having adjacent wavelengths.

The distribution of the light emitters for each channel can provide a grouping of the various wavelengths according to the following distribution:
- a first lighting channel provides at least one light emitter with a wavelength comprised between approximately 310 nm and approximately 340 nm;
- a second lighting channel provides at least one light emitter with a wavelength comprised between approximately 365 nm and approximately 405 nm;
- a third lighting channel provides at least one light emitter with a wavelength comprised between approximately 425 nm and approximately 450 nm;
- a fourth lighting channel provides at least one light emitter with a wavelength comprised between approximately 470 nm and approximately 490 nm;
- a fifth lighting channel provides at least one light emitter with a wavelength of approximately 505 nm;
- a sixth and a seventh lighting channel provides at least one light emitter with a wavelength of approximately 550 nm;
- an eighth lighting channel provides at least one light emitter with a wavelength of approximately 625 nm;
- a ninth lighting channel provides at least one light emitter with a wavelength comprised between approximately 630 nm and approximately 680 nm;
- a tenth lighting channel provides at least one light emitter with a wavelength comprised between approximately 700 nm and approximately 720 nm;
- an eleventh lighting channel provides at least one light emitter with a wavelength comprised between approximately 740 nm and approximately 750 nm;
- a twelfth lighting channel provides at least one light emitter with a wavelength comprised between approximately 780 nm and approximately 810 nm;
- a thirteenth lighting channel provides at least one light emitter with a wavelength comprised between approximately 850 nm and approximately 910 nm;
- a fourteenth lighting channel provides at least one light emitter with a wavelength of approximately 980 nm;
- a fifteenth lighting channel provides at least one light emitter with a wavelength comprised between approximately 1050 nm and approximately 1100 nm; and
- a sixteenth lighting channel provides at least one light emitter with a wavelength of approximately 1200 nm.

In accordance with another aspect of the present invention, each light emitter has an emission angle comprised between approximately ±55° and approximately ±65°, with respect to an emission plane substantially orthogonal to the electronic support, to guarantee an optimal uniformity of spectrum and radiance.

In accordance with another aspect of the present invention, the command unit comprises eight command channels independent of each other. Advantageously, the command interface is configured to connect each of the command channels to a pair of the lighting channels.

Alternatively, the light emission device according to the present invention can provide two command units electronically connected in parallel to the lighting unit. In one possible solution of this type, the command interfaces of each command unit are configured to connect the respective command channels to corresponding individual lighting channels.

In accordance with another aspect of the present invention, the command unit comprises at least one controller member, or integrated microcontroller, which is electronically connected at least to each of the command channels and to the connection input, and is configured at least to select each given electric signal of each of the command channels and to process in terms of temperature the signal received from the control element through the connection input.

In this way, it is also possible to program, even remotely, the operating functions and safety parameters of the entire light emission device according to the present invention, as a function of the specific conditions and of the specific operating needs required. In the same way, it is possible to vary these parameters, or implement or reduce the number of command units connected to the lighting unit, as well as reduce or implement the number of lighting units connected to one or more command units, thus providing a substantially modular system that does not require any interventions whatsoever for the complete replacement of the light emission device itself.

### DESCRIPTION OF THE DRAWINGS

These and other aspects, characteristics and advantages of the present invention will become apparent from the following description of an embodiment, given as a non-restrictive example with reference to the attached drawings wherein:
- fig. 1 shows a schematic plan view of a first operating configuration of a light emission device according to the present invention;
- fig. 2 shows a schematic plan view of a second operating configuration of the light emission device according to the present invention;
- fig. 3 is an emulation graph of a first arbitrary light emission spectrum emitted by a light emission device according to the present invention;
- fig. 4 is an emulation graph of a second arbitrary light emission spectrum emitted by a light emission device according to the present invention; and
- fig. 5 shows a schematic plan view of an alternative layout of the light emission device according to the present invention.

We must clarify that the phraseology and terminology used in the present description, as well as the figures in the attached drawings also in relation as to how described, have the sole function of better illustrating and explaining the present invention, their purpose being to provide a non-limiting example of the invention itself, since the scope of protection is defined by the claims.

To facilitate comprehension, the same reference numbers have been used, where possible, to identify identical common elements in the drawings. It is understood that elements and characteristics of one embodiment can be conveniently combined or incorporated into other embodiments without further clarifications.

### DESCRIPTION OF AN EMBODIMENT OF THE PRESENT INVENTION

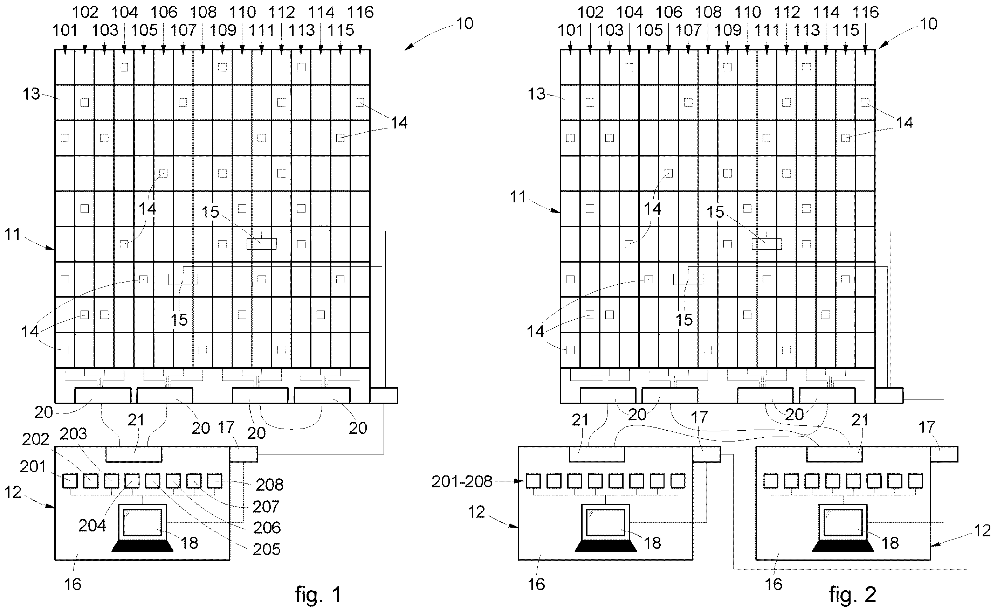

With reference to figs. 1 and 2, two possible modular configurations of a light emission device 10 according to the present invention are schematically shown.

It should be considered that what is shown is not intended to represent an actual operating configuration of the device 10 according to the present invention, but is representative of its components and main functionalities aimed at overcoming the technical problems addressed.

Essentially, the device 10 according to the present invention comprises at least one lighting unit 11 and at least one command unit 12, electronically connected to each other. In both of the solutions shown, but also in other possible solutions permitted by the inventive idea according to the present invention, the electronic connection between the lighting unit 11 and the command unit 12 is schematically represented by means of a curvilinear segment, to generalize any possible electronic connection whatsoever of a known type between the parts, whether by direct connection, cable, radio, Bluetooth^{®}, Wi-Fi connection, or other known type.

The device 10 according to the present invention finds advantageous, although not exclusive, application in the simulation of solar radiation in simulator apparatuses whose main function is to test, in a continuous mode, that is, for a prolonged period of time, even for entire days, the operation of objects, of a known type and not shown, such as photovoltaic modules or panels, or photovoltaic strings or cells, or others.

In fact, the lighting unit 11 can be designed both to emulate sunlight according to certain emulation standards, and also to be integrated into high energy-saving class solar simulators. In particular, the lighting unit 11 guarantees in and of itself, that is, without the need for additional components, an SPC (*Spectral Coverage*) of 100% in the spectral range comprised between 300 nm and 1260-1300 nm, an SPD (*Spectral Deviation*) of less than 13.7% and a spectral match of more than 99% in all six bands defined by regulations.

The lighting unit 11 substantially comprises an electronic support 13 on which a plurality of light emitters, or more simply LEDs 14, of different types are disposed in a flat matrix, as explained in greater detail below.

The electronic support 13 substantially consists of an aluminum plate, although it is not excluded that it can be made of other materials, such as for example copper, vetronite or suchlike, suitable for the purpose of stably supporting the LEDs 14, allowing a reciprocal and effective electronic connection thereof, substantially without signal interferences.

In this specific case, up to one hundred and forty-four commercial type LEDs 14 can be mounted on the electronic support 13, which are disposed in a checkerboard pattern and divided into sixteen independent lighting channels, indicated with progressive numbers from 101 to 116, each of which can support up to nine LEDs 14 connected in series with each other. Each individual lighting channel 101-116 contains different types of LEDs 14 with adjacent wavelengths, allowing a precise calibration and customization of the spectral properties of the entire lighting unit 11, for example through the command variations provided by the command unit 12.

On the electronic support 13 there are also provided connection interfaces 20, in this specific case four, forming part of the lighting unit 11 and each electronically connected to specific lighting channels 101-116 and selectively connectable to the command unit 12, so as to transmit a given signal coming from the command unit 12 to each lighting channel 101-116.

In addition, on the lighting unit 11 there are provided two control elements, or temperature probes 15, such as for example two NTCs, PTCs, or thermocouples, positioned in strategic positions in the lay-out of the electronic support 13, for the accurate detection of the temperature of the various LEDs 14.

In this specific case, to guarantee the maximum versatility in the calibration and customization of the spectrum, the lighting unit 11 is advantageously made without the use of white LEDs 14, which limit the calibration of a light source in compliance with class A relating to the spectral match of a solar simulator.

In the basic configuration, as representatively schematized in figs. 1 and 2, thirty different types of LEDs 14 are deliberately distributed on the electronic support 13, for a total of ninety-nine LEDs 14.

The layout of choice of the LEDs 14 to be distributed on the channels 101-116 provides that:
- the first lighting channel 101 is set up with at least one LED 14 with a wavelength of 310 nm, at least one LED 14 with a wavelength of 325 nm and at least one LED 14 with a wavelength of 340 nm;
- the second lighting channel 102 is set with at least one LED 14 with a wavelength of 365 nm, at least one LED 14 with a wavelength of 385 nm and at least one LED 14 with a wavelength of 405 nm;
- the third lighting channel 103 is set up with at least one LED 14 with a wavelength of 425 nm and at least one LED 14 with a wavelength of 450 nm;
- the fourth lighting channel 104 is set up with at least one LED 14 with a wavelength of 470 nm and at least one LED 14 with a wavelength of 490 nm;
- the fifth lighting channel 105 is set up with at least one LED with a wavelength of 505 nm;
- the sixth lighting channel 106 and the seventh lighting channel 107 are both set up with at least one respective LED 14 with a wavelength of 550 nm;
- the eighth lighting channel 108 is set up with at least one LED 14 with a wavelength of 625 nm;
- the ninth lighting channel 109 is set up with at least one LED 14 with a wavelength of 630 nm, at least one LED 14 with a wavelength of 660 nm and at least one LED 14 with a wavelength of 680 nm;
- the tenth lighting channel 110 is set up with at least one LED 14 with a wavelength of 700 nm and at least one LED 14 with a wavelength of 720 nm;
- the eleventh lighting channel 112 is set up with at least one LED 14 with a wavelength of 740 nm and at least one LED 14 with a wavelength of 750 nm;
- the twelfth lighting channel 112 is set up with at least one LED 14 with a wavelength of 780 nm, at least one LED 14 with a wavelength of 790 nm and at least one LED with a wavelength of 810 nm;
- the thirteenth lighting channel 113 is set up with at least one LED 14 with a wavelength of 850 nm, at least one LED 14 with a wavelength of 880 nm and at least one LED 14 with a wavelength of 910 nm;
- the fourteenth lighting channel 114 is set up with at least one LED 14 with a wavelength of 980 nm;
- the fifteenth lighting channel 115 is set up with at least one LED 14 with a wavelength of 1050 nm and at least one LED 14 with a wavelength of 1100 nm; and
- the sixteenth lighting channel 116 is set up with at least one LED 14 with a wavelength of 1200 nm.

It is clear that the distribution and wavelengths described here are intended to illustrate only one of the different lighting and lay-out configurations that are possible with the inventive idea according to the present invention.

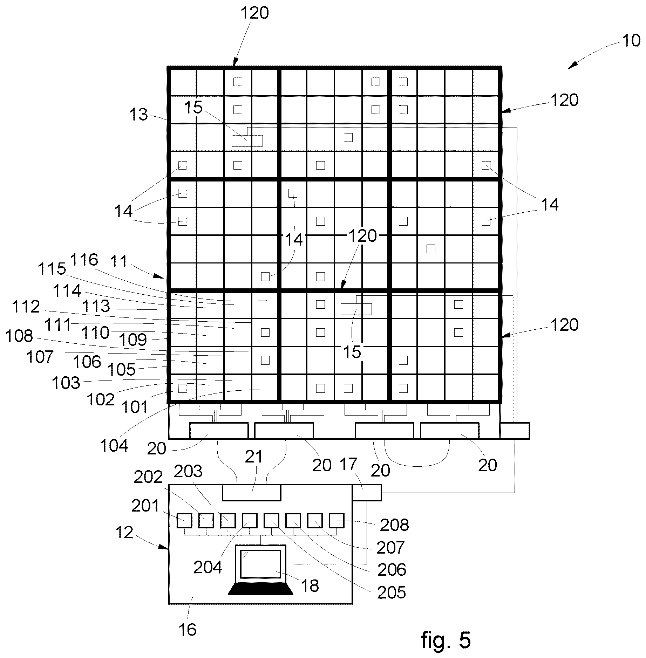

For example, as schematically shown in fig. 5, the LEDs 14 are grouped substantially uniformly into nine zones or sectors 120, each of which comprises at most one LED 14 per channel 101-116, that is, each channel 101-116 can provide at most one LED 14 for each sector 120.

For illustrative convenience, in fig. 5 the channels 101-116 have been numbered only on one of the nine sectors 120, but it is clear that the same numerical references are to be understood in the same way on all the other eight sectors 120. In the same way, even if not shown specifically, the electronic support 13 with the same lay-out with sectors 120 can be freely connected to a command unit 12, or to two command units 12, in the same way as what provided for the lay-outs shown in figs. 1 and 2.

This distribution into zones or sectors 120, with LEDs uniformly distributed in each of the sectors 120, allows to guarantee the maximum spectral uniformity, therefore it guarantees an optimal condition of emission and therefore of simulation over the entire spectrum.

Furthermore, each LED 14 has an emission angle comprised between approximately ±55° and approximately ±65° with respect to a hypothetical emission plane which is substantially orthogonal to the electronic support 13, in order to guarantee an optimum uniformity of spectrum and radiance.

It is clear that the lighting unit 11 can be customized further, without any design modifications, by mounting suitable commercial LEDs 14 to extend the spectrum beyond 1260 nm or below 300 nm.

It is also clear that the lighting unit 11 can be connected both to the command unit 12 and also to other suitable devices.

One of the main advantages of the lighting unit 11 according to the present invention is ease of use, since it also possible to reduce the number of lighting channels 101-116 from sixteen to eight by applying a special connector to connect the lighting channels 101-116 in series two by two (fig. 1), while continuing to guarantee the specifications required to create simulators in a low energy class, maintaining the high standards of SPC = 100%, SPD < 16.2% and spectral match > 99%.

The command unit 12 also comprises an electronic support 16 on which eight independent command channels are provided, indicated with progressive numbers from 201 to 208, each of which can deliver at output a constant current comprised between 0 A and 1.5 A. The device can be powered by a DC voltage comprised between approximately 24 V and approximately 55 V. Depending on the power supply voltage, the maximum power delivered by each individual command channel 201-208 ranges from approximately 36 W (at 24 V) to approximately 82.5 W (at 55 V).

In this way, the device 10 according to the present invention allows to optimize the energy efficiency of the system, significantly reducing the problems related to the self-heating of the unit. This allows a continued use of the command unit 12, even at maximum power, without the need to adopt solutions to cool the command unit 12 itself.

Furthermore, each command channel 201-208 of the command unit 12, in conjunction with the delivery of current, allows to measure both the actual voltage and the actual current applied at output, effectively making the device a current/voltage measurement unit with eight semi-independent channels. This feature makes the command unit 12 substantially independent of the lighting unit 11, since it can be used in different applications both for driving current loads and also for measurements of multi-terminal electrical/electronic devices.

Each command channel 201-208 is equipped with an off circuit, not shown, which employs a MOSFET *(Metal-Oxide-Semiconductor Field-Effect Transistor)* to force both the output current and voltage to zero in less than 1µs, allowing, for example, the almost instantaneous shutdown of the lighting unit 11.

On the electronic support 16 there is also provided a command interface 21 forming part of the command unit 12, electronically connected to the command channels 201-208 and selectively connectable to the lighting unit 11 by means of the connection interfaces 20, so as to transmit a given signal coming from the command channels 201-208 to each lighting channel 101-116.

Please note how in fig. 1 a first possible type of connection between the command interface 21 and the connection interfaces 20 is simplified, in which there is only one command unit 12 connected to a corresponding lighting unit 11, with each command channel 201-208 connected to a pair of lighting channels 101-116, while in the example of fig. 2 there is a second possible type of connection between two command interfaces 21 of two command units 12 and the connection interfaces 20 of a single lighting unit, in which each command channel 201-208 is connected to a corresponding lighting channel 101-116.

Furthermore, the command unit 12 comprises a plurality of connection inputs 17 configured to be electronically connected to the temperature probes 15 of the lighting unit 11, allowing to monitor the temperature of the latter and, possibly, of the command unit 12 itself.

The command unit 12 also comprises an integrated controller member, or microcontroller 18, which is electronically connected to each of the command channels 201-208 and to the connection inputs 17, which is configured at least to select each given electric signal of each of the command channels 201-208 and process in terms of temperature the signal received from the temperature probes 15.

An example of an integrated microcontroller 18 allows to perform the following functionalities:
- UART interface *(Universal Asynchronous Receiver-Transmitter)* with baud rate of up to 115200 for remote control of the device;
- selection of the current of each individual channel with a resolution of 0.3 mA;
- sequential monitoring of delivered currents, applied voltages and temperatures;
- implementation of prediction algorithms for the management of the lighting unit 11 to keep the radiance and spectrum levels of the individual lighting channels 101-116 constant over time, regardless of the operating temperature of the LEDs 14 and the control unit 12; and
- independent management of the individual lighting channels 101-116 using algorithms predicting the temperature of the LEDs 14 of the individual lighting channels 101-116 through monitoring of the voltage of the individual lighting channels 101-116.

With the device 10 according to the present invention, therefore, an effective and qualitatively high management of the customization of the arbitrary spectrum emitted by the lighting unit 11 is possible.

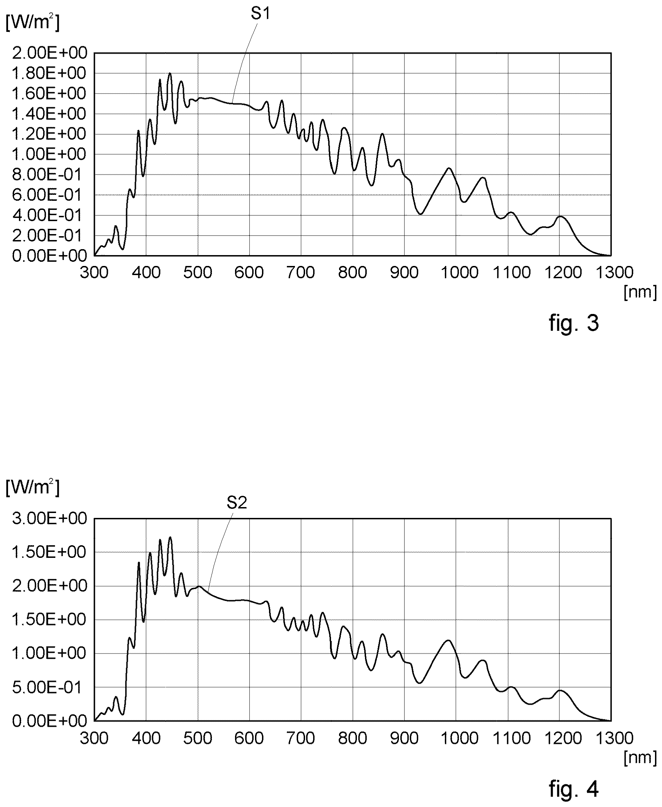

Some examples to compare are schematized in the graphs shown in figs. 3 and 4.

For example, fig. 3 shows the trend of an arbitrary spectrum S1 that emulates a reference spectrum AM1.5G for ground applications, with SPD = 13.7%, SPC = 100% and Spectral Match > 99% over all the bands defined by the CEI EN IEC 60904-9 standard, while fig. 4 shows the trend of an arbitrary spectrum S2 that emulates the reference spectrum AM0 for aerospace applications, in the range between 300 nm and 1200 nm, with SPD = 19.8%, SPC = 95% and Spectral Match > 90%.

In particular, the arbitrary spectrum S1 is an example of simulation of terrestrial solar radiation; while the spectrum S2 is an example of solar radiation simulation in space. The spectrum S2, compared to the spectrum S1, is characterized by a greater amplitude (power) of all components, including a marked increase in the spectral component between 350 nm and 500 nm, and between 900 nm and 100 nm.

It is clear that modifications and/or additions of parts may be made to the device 10 as described heretofore, without thereby departing from the field and scope of the present invention, as defined by the claims.

It is also clear that, although the present invention has been described with reference to some specific examples, a person of skill in the art will be able to achieve other equivalent forms of light emission device, having the characteristics as set forth in the claims and hence all coming within the field of protection defined thereby.

In the following claims, the sole purpose of the references in brackets is to facilitate their reading and they must not be considered as restrictive factors with regard to the field of protection defined by the claims.

## Claims

1. Light emission device (10), for performing tests on at least one object, said device comprising at least:
- a lighting unit (11) provided with an electronic support (13) on which LED light emitters (14) are disposed in a flat matrix; and
- one command unit (12) configured to command the selective activation of one, or groups, of said light emitters (14),
**characterized in that** said lighting unit (11) comprises a connection interface (20) mounted on said electronic support (13) and electronically connected to said light emitters (14), a plurality of lighting channels (101-116) independent of each other and each consisting of one or more light emitters (14), and a control element (15) mounted on said electronic support (13) and configured to measure the temperature of at least part of said light emitters (14), **and in that** said command unit (12) comprises a plurality of command channels (201-208) independent of each other and each configured to deliver at output an electric signal to at least one corresponding one of said lighting channels (101-116), a command interface (21) electronically connected to each of said command channels (201-208) and selectively interconnected with said connection interface (20), and at least one connection input (17) electronically connected to said control element (15), wherein said lighting unit (11) comprises sixteen lighting channels (101-116) each consisting of up to a maximum of nine light emitters (14) connected in series with each other and having adjacent wavelengths, and wherein:
- a first lighting channel (101) provides at least one light emitter (14) with a wavelength comprised between approximately 310 nm and approximately 340 nm;
- a second lighting channel (102) provides at least one light emitter (14) with a wavelength comprised between approximately 365 nm and approximately 405 nm;
- a third lighting channel (103) provides at least one light emitter (14) with a wavelength comprised between approximately 425 nm and approximately 450 nm;
- a fourth lighting channel (104) provides at least one light emitter (14) with a wavelength comprised between approximately 470 nm and approximately 490 nm;
- a fifth lighting channel (105) provides at least one light emitter (14) with a wavelength of approximately 505 nm;
- a sixth lighting channel (106) and a seventh lighting channel (107), provides at least one light emitter (14) with a wavelength of approximately 550 nm;
- an eighth lighting channel (108) provides at least one light emitter (14) with a wavelength of approximately 625 nm;
- a ninth lighting channel (109) provides at least one light emitter (14) with a wavelength comprised between approximately 630 nm and approximately 680 nm;
- a tenth lighting channel (110) provides at least one light emitter (14) with a wavelength comprised between approximately 700 nm and approximately 720 nm;
- an eleventh lighting channel (111) provides at least one light emitter (14) with a wavelength comprised between approximately 740 nm and approximately 750 nm;
- a twelfth lighting channel (112) provides at least one light emitter (14) with a wavelength comprised between approximately 780 nm and approximately 810 nm;
- a thirteenth lighting channel provides (113) at least one light emitter (14) with a wavelength comprised between approximately 850 nm and approximately 910 nm;
- a fourteenth lighting channel (114) provides at least one light emitter (14) with a wavelength of approximately 980 nm;
- a fifteenth lighting channel (115) provides at least one light emitter (14) with a wavelength comprised between approximately 1050 nm and approximately 1100 nm; and
- a sixteenth lighting channel (116) provides at least one light emitter (14) with a wavelength of approximately 1200 nm.

2. Device (10) as in claim 1, **characterized in that** each of said light emitters (14) has an emission angle comprised between approximately ±55° and approximately ±65°, with respect to an ideal emission plane, substantially orthogonal to said electronic support (13), so as to guarantee the characteristics of spectral uniformity.

3. Device (10) as in claim 1 or 2, **characterized in that** said lighting unit (11) is configured to guarantee in itself an SPC *(Spectral Coverage)* of 100% in the spectral range comprised between 300 nm and 1300 nm.

4. Device (10) as in any claim hereinbefore, **characterized in that** said command unit (12) comprises eight command channels (201-208) independent of each other.

5. Device (10) as in claim 4, **characterized in that** it comprises up to 255 command units (12) communicating with a single communication bus to command up to 2040 command channels independent of each other.

6. Device (10) as in any claim hereinbefore, **characterized in that** said command interface (21) is configured to connect each of said command channels (201-208) to a pair of said lighting channels (101-116).

7. Device (10) as in claim 4, **characterized in that** it comprises two command units (12) electronically connected in parallel to said lighting unit (11), to switch from an 8 channel configuration to a 16 channel one, **and in that** the command interfaces (21) of each of said command units (12) are configured to connect the respective command channels (201-208) to corresponding individual lighting channels (101-116).

8. Device (10) as in any claim hereinbefore, **characterized in that** said command unit (12) comprises at least one controller member (18) electronically connected to each of said command channels (201-208) and to said connection input (17), and configured at least to select each given electric signal of each of said command channels (201-208) and to process in terms of temperature the signal received from said connection input (17).

9. Device (10) as in any claim hereinbefore, **characterized in that** said LEDs (14) are grouped uniformly into nine zones or sectors (120), each of which comprises, at most, one LED (14) per channel (101-116), that is, each channel (101-116) provides at most one LED (14) for each sector (120).

10. Lighting unit (11) for a light emission device (10) as in any claim hereinbefore, for performing tests on at least one object, provided with at least one electronic support (13) on which a plurality of LED light emitters (14) are disposed in a flat matrix, and configured to position at least part of said light emitters (14) toward said object, **characterized in that** it comprises at least one connection interface (20) mounted on said electronic support (13) and electronically connected to said light emitters (14), a plurality of lighting channels (101-116) independent of each other and each consisting of one or more light emitters (14), and at least one thermistor control element (15) mounted on said electronic support (13) and configured to measure the temperature of at least part of said light emitters (14).

11. Command unit (12) for a light emission device (10) as in any claim hereinbefore, for performing tests on at least one object, configured to command the selective activation of one, or groups, of LED light emitters (14), **characterized in that** it comprises a plurality of command channels (201-208) independent of each other and each configured to deliver at output a certain electric command signal for said light emitters (14), a command interface (21) electronically connected to each of said command channels (201-208), and at least one connection input (17) configured to be electronically connected to a control element (15).
